# EUROPEAN PATENT APPLICATION

(11) **EP 2 862 709 A1**
(43) Date of publication of application: **22.04.2015**
(21) Application number: 14152458.7
(22) Date of filing: 24.01.2014
(51) Int. Cl.: B32B 7/00, B32B 7/02, B32B 7/04, B32B 9/00, B32B 15/00, B32B 15/04, B32B 15/08, B32B 27/00, B32B 27/06, B32B 1/00, B32B 1/04, B32B 3/00, B32B 3/02, B32B 3/26, B32B 3/30, H01L 21/00

(54) **Substrate assembly of heterogeneous materials and method for making the same**

(30) Priority: 21.10.2013 TW 102137913
(71) Applicant: Taiwan Green Point Enterprises Co., Ltd., Daya Township, Taichung County 42865 (TW)
(72) Inventor: Kuo, Nan-Hui, 42865 Taichung City (TW); Tetz, Schemm, 42865 Taichung City (TW); Huang, Yulung, 42865 Taichung City (TW); Tsai, Yung-Hsien, 42865 Taichung City (TW)
(74) Representative: Oxley, Rachel Louise

(57) **Abstract**

A substrate assembly of heterogeneous materials includes: a substrate (2) having an outer surface (23) and formed with first and second channels (21, 22), the outer surface (23) havingfirst, second and third regions (231, 232, 233), the first and second regions (231, 232) being non-coplanar, the second and third regions (232, 233) being non-coplanar, the first channel (21) extending inwardly from the first region (231) in a first direction (213), the second channel (22) extending inwardly from the third region (233) in a second direction (223) that crosses the first direction (213); and a mounting seat (3) having an outer layer (33) and first and second inner protrusions (31, 32). The outer layer (33) is formed on the first and third regions (231, 233) . The first and second inner protrusions (31, 32) extend respectively into the first and second channels (21, 22).

## Description

The invention relates to a substrate assembly and a method for making the same, more particularly to a substrate assembly of heterogeneous materials.

Taiwanese patent application publication No. 201342454 discloses a method of binding a plastic material and metal together to forma substrate assembly. The substrate assembly comprises a metal substrate having an outer surface and a plurality of micro-holes formed in the outer surface. The plastic material extends into the micro-holes so as to secure the plastic material to the outer surface of the metal substrate.

Since the micro-holes extend vertically and inwardly from the outer surface of the metal substrate and are parallel to one another, and since the plastic material and the metal substrate are heterogeneous materials with different physical properties, the plastic material is likely to separate from the metal substrate when the substrate assembly is subjected to an external force which acts on the outer surface and which has a direction perpendicular to the outer surface.

Therefore, an object of the present invention is to provide a substrate assembly of heterogeneous materials that can overcome the aforesaid drawback associated with the prior art. Another object of the present invention is to provide a method of manufacturing a substrate assembly of heterogeneous materials.

According to one aspect of the present invention, there is provided a substrate assembly of heterogeneous materials. The substrate assembly includes: a substrate made from a first material, having an outer surface, and formed with at least first and second channels, the outer surface having first, second and third regions, the first and second regions being non-coplanar, the second and third regions being non-coplanar, the first channel extending inwardly from the first region toward the second region in a first direction, and having a first end that terminates at the first region and a second end that is distal from the first end, the second channel extending inwardly from the third region in a second direction that crosses the first direction, and having a first end that terminates at the third region, and a second end that is distal from the first end of the second channel; and a mounting seat having an outer layer and at least first and second inner protrusions that protrude outwardly from the outer layer. The outer layer is formed on the first and third regions. The first and second inner protrusions extend respectively through the first ends of the first and second channels and into the first and second channels toward the second ends of the first and second channels. The mounting seat is made from a second material that has a melting point less than that of the first material.

According to another aspect of the present invention, there is provided a method of manufacturing a substrate assembly of heterogeneous materials. The method comprises: providing a substrate having an outer surface that has first, second and third regions, the first and second regions being non-coplanar, the second and third regions being non-coplanar; forming at least first and second channels in the substrate, the first channel extending inwardly from the first region toward the second region in a first direction, and having a first end that terminates at the first region and a second end that is distal from the first end, the second channel extending inwardly from the third region in a second direction that crosses the first direction, and having a first end that terminates at the third region, and a second end that is distal from the first end of the second channel; and forming a mounting seat having an outer layer and at least first and second inner protrusions that protrude outwardly from the outer layer. The outer layer is formed on the first and third regions. The first and second inner protrusions extend respectively through the first ends of the first and second channels and into the first and second channels toward the second ends of the first and second channels. The mounting seat is made from a second material that has a melting point less than that of the first material.

In drawings which illustrate embodiments of the invention,
Fig. 1 is a perspective view of the first preferred embodiment of a substrate assembly of heterogeneous materials according to the present invention;
Fig. 2 is a sectional view taken along line II-II of Fig. 1;
Fig. 3 is a perspective view of the second preferred embodiment of the substrate assembly according to the present invention;
Fig. 4 is a sectional view of the third preferred embodiment of the substrate assembly according to the present invention;
Fig. 5 is a perspective view of the fourth preferred embodiment of the substrate assembly according to the present invention;
Fig. 6 is a sectional view of the fifth preferred embodiment of the substrate assembly according to the present invention; and
Fig. 7 is a flow chart of a method of manufacturing the substrate assembly of the present invention.

Before the present invention is described in greater detail with reference to the accompanying preferred embodiments, it should be noted herein that like elements are denoted by the same reference numerals throughout the disclosure.

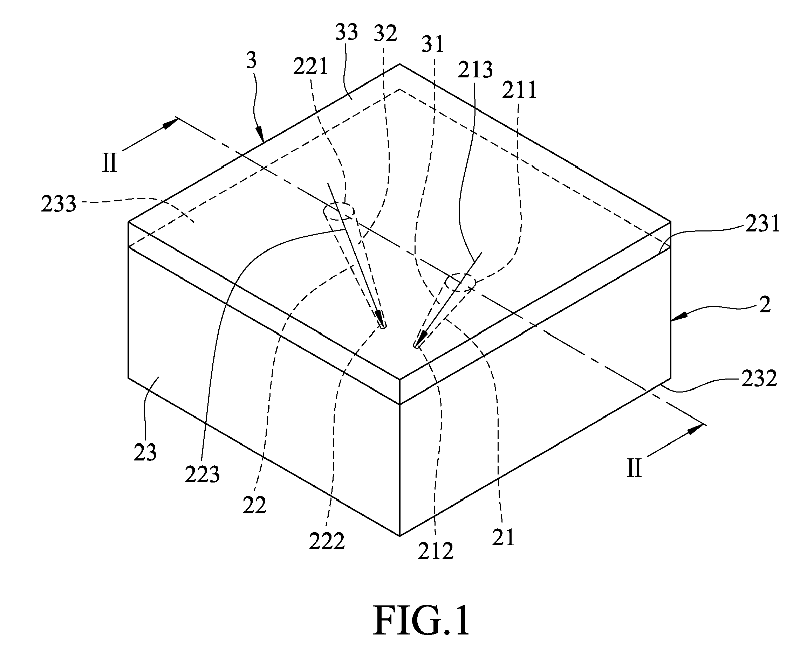

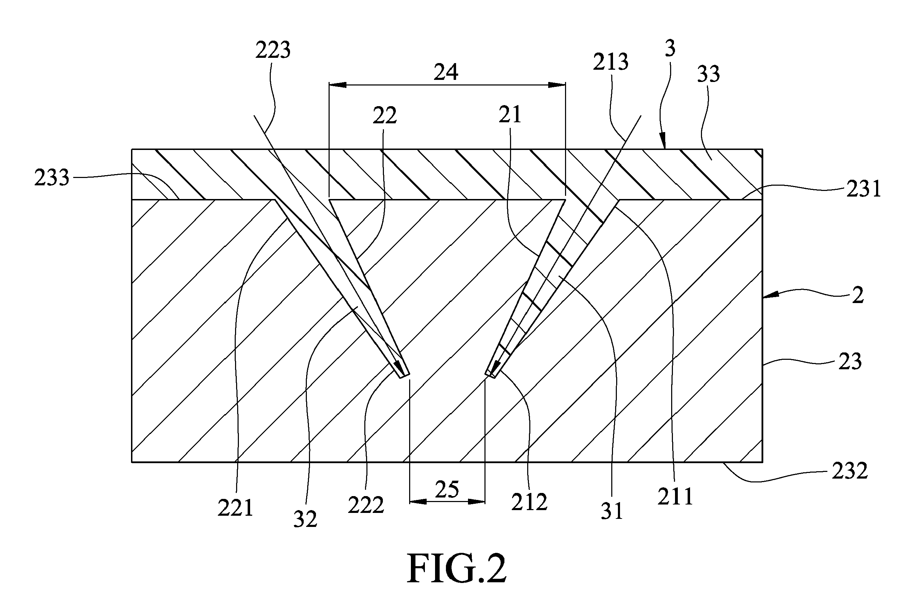

Fig. 1 and Fig. 2 illustrate the first preferred embodiment of a substrate assembly of heterogeneous materials according to the present invention. The substrate assembly can be used for making products, such as circuit boards, touch panels, display panels, plastic shells and mobile phone shells.

The substrate assembly includes a substrate 2 and a mounting seat 3.

The substrate 2 is made from a first material, has an outer surface 23, and is formed with at least first and second channels 21, 22. The outer surface 23 has first, second and third regions 231, 232, 233. The first and second regions 231, 232 are non-coplanar, and the second and third regions 232, 233 are also non-coplanar. The first channel 21 extends inwardly from the first region 231 toward the second region 232 in a first direction 213, and has a first end 211 that terminates at the first region 231 and a second end 212 that is distal from the first end 211. The second channel 22 extends inwardly from the third region 233 in a second direction 223 that crosses the first direction 213, and has a first end 221 that terminates at the third region 233, and a second end 222 that is distal from the first end 221 of the second channel 22.

The mounting seat 3 has an outer layer 33 and at least first and second inner protrusions 31, 32 that protrude outwardly from the outer layer 33. The outer layer 33 is formed on the first and third regions 231, 233. The first and second inner protrusions 31, 32 extend respectively through the first ends 211, 221 of the first and second channels 21, 22 and into the first and second channels 21, 22 toward the second ends 212, 222 of the first and second channels 21, 22. The mounting seat 3 is made from a second material that has a melting point less than that of the first material.

In this embodiment, the first ends 211, 221 of the first and second channels 21, 22 are spaced apart from each other by a first distance 24. The second ends 212, 222 of the first and second channels 21, 22 are spaced apart from each other by a second distance 25 that is different from the first distance 24. The first distance 24 is greater than the second distance 25 in this embodiment.

In this embodiment, the first and third regions 231,233 are coplanar. The second channel 22 extends inwardly and obliquely relative to the third region 233 from the third region 233 toward the second region 232 in the second direction 223.

Preferably, the second material is molded over the outer surface 23 of the substrate 2 to form the mounting seat 3 using a conventional molding technique, such as injection molding.

Preferably, the first material is metal, and the second material is selected from the group consisting of a plastic material, glass, and a ceramic material. More preferably, the second material is a plastic material.

In this embodiment, the first and second channels 21, 22 are conical in shape.

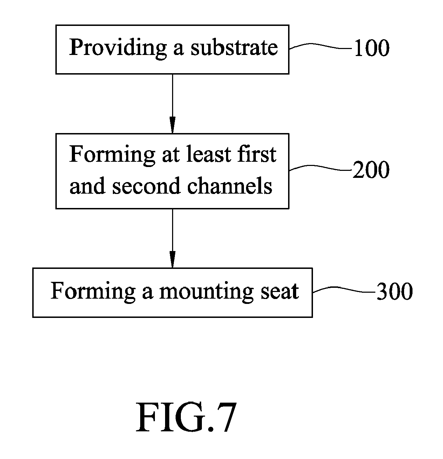

Fig. 7 illustrates consecutive steps of a method of manufacturing the substrate assembly of the preferred embodiment according to the present invention.

The method includes: providing the substrate 2 of the first material (step 100); forming the first and second channels 21, 22 in the substrate 2 using conventional techniques, such as laser drilling, mechanical drilling, stamping, or chemical etching (step 200); and forming the mounting seat 3 on the first and third regions 231, 233 by molding the second material over the first and third regions 231, 233 using injection molding techniques (step 300).

Preferably, formation of the first and seconds channels 21, 22 is conducted by laser drilling, which is advantageous in forming roughened channel-defining surfaces that define the first and second channels 21, 22. The roughened channel-defining surfaces have micro-structures that can enhance the bonding strength between the substrate 2 and the mounting seat 3. Moreover, slag is normally generated from the laser drilling and may securely attach to the roughened channel-defining surfaces, which further increases the bonding strength between the substrate 2 and the mounting seat 3.

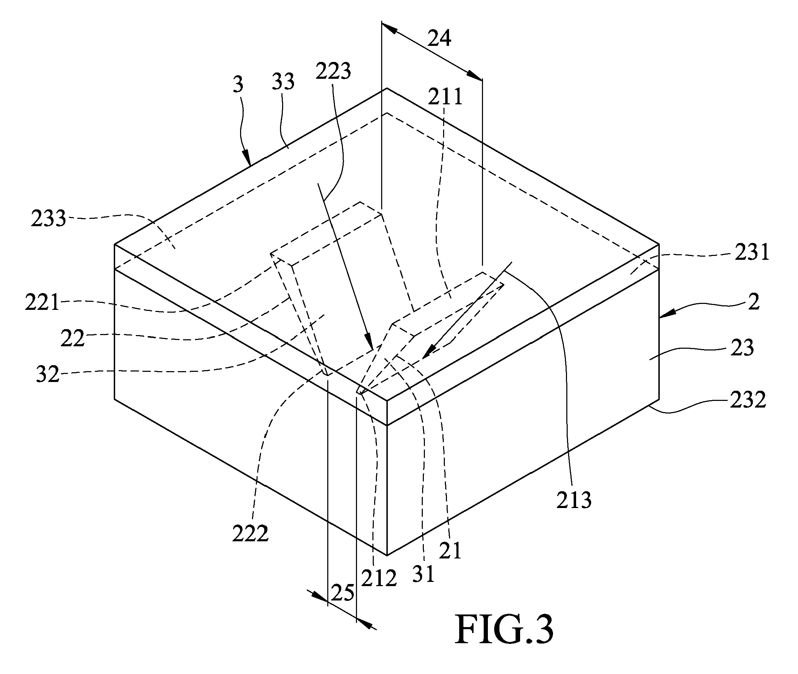

Fig. 3 illustrates the second preferred embodiment of the substrate assembly according to the present invention. The second preferred embodiment differs from the previous embodiment in that the first and second channels 21, 22 are triangular in shape.

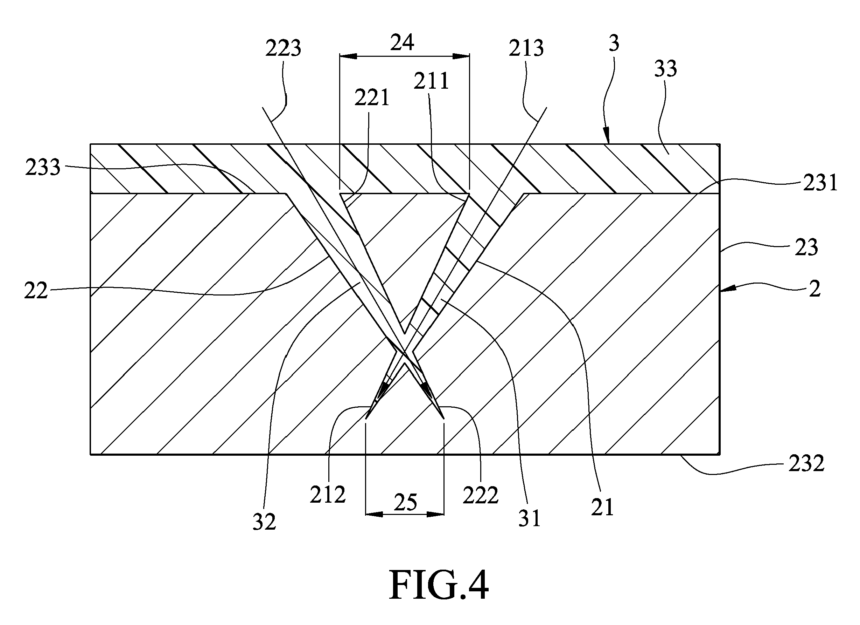

Fig. 4 illustrates the third preferred embodiment of the substrate assembly according to the present invention. The third preferred embodiment differs from the first preferred embodiment in that the first and second channels 21, 22 intersect each other and the first and second inner protrusions 31, 32 intersect each other. The arrangement of the first and second channels 21, 22 is advantageous in that, during the process of forming the mounting seat 3, air in the first channel 21 can be discharged through the second channel 22 when the second material is injected into the first channel 21, which prevents formation of air gaps under the first and second inner protrusions 31, 32 in the channels 21, 22.

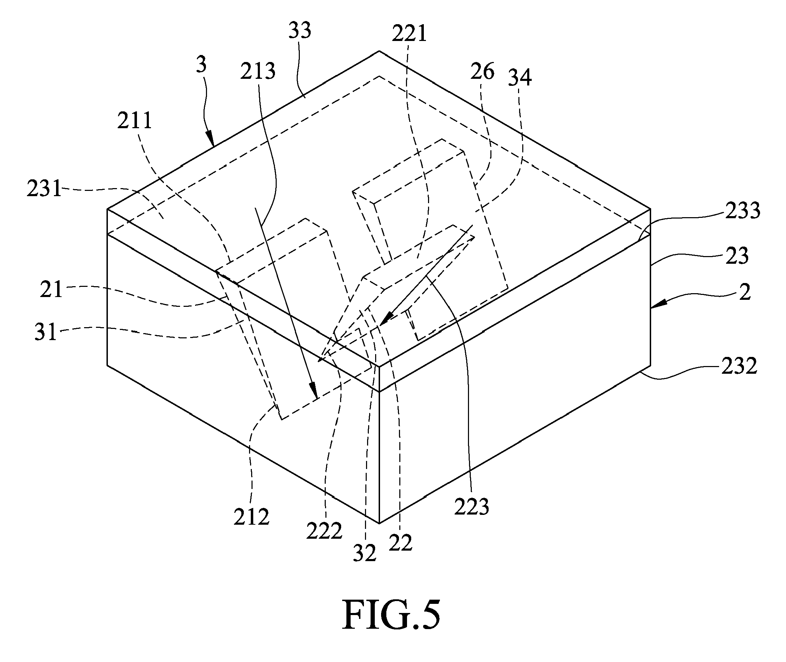

Fig. 5 illustrates the fourth preferred embodiment of the substrate assembly according to the present invention. The fourth preferred embodiment differs from the first preferred embodiment in that the substrate 2 is further formed with a third channel 26 which extends inwardly and obliquely from the first region 231 toward the second region 232 in the first direction 213 and which is spaced apart from the first channel 21. In this embodiment, the mounting seat 3 further has a third inner protrusion 34 that protrudes from the outer layer 33 into the third channel 26.

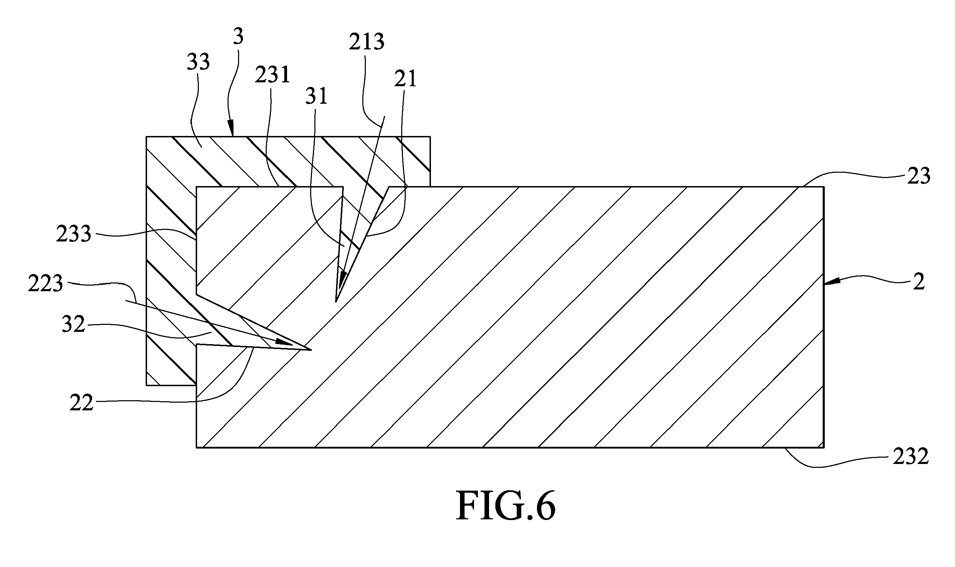

Fig. 6 illustrates the fifth preferred embodiment of the substrate assembly according to the present invention. The fifth preferred embodiment differs from the first preferred embodiment in that the first and third regions 231, 233 are non-coplanar, and the third region 233 extends between the first and second regions 231, 232. In this embodiment, the second channel 22 extends inwardly and obliquely relative to the third region 233 from the third region 233 toward the first channel 21 in the second direction 223.

The advantages of the present invention can be summarized as follows. Since the first and second channels 21, 22 extend inwardly and respectively from the first and third regions 231, 233 in different directions that cross each other, the first and second inner protrusions 31, 32, which extend respectively in the first and second channels 21, 22, can have a stronger anchoring to the substrate 2 as compared to the plastic material of the aforesaid conventional substrate assembly. In addition, by the arrangement where the first and second channels 21, 22 intersect each other, the first and second inner protrusions 31, 32 can intersect each other and be connected together, thereby enhancing the anchoring of the first and second inner protrusions 31, 32 to the substrate 2.

## Claims

1. A substrate assembly of heterogeneous materials, **characterized by**:
a substrate (2) made from a first material, having an outer surface (23), and formed with at least first and second channels (21, 22), said outer surface (23) having first, second and third regions (231, 232, 233), said first and second regions (231, 232) being non-coplanar, said second and third regions (232, 233) being non-coplanar, said first channel (21) extending inwardly from said first region (231) toward said second region (232) in a first direction (213), and having a first end (211) that terminates at said first region (231) and a second end (212) that is distal from said first end (211), said second channel (22) extending inwardly from said third region (233) in a second direction (223) that crosses the first direction (213), and having a first end (221) that terminates at said third region (233), and a second end (222) that is distal from said first end (221) of said second channel (22); and
a mounting seat (3) having an outer layer (33) and at least first and second inner protrusions (31, 32) that protrude outwardly from said outer layer (33), said outer layer (33) being formed on said first and third regions (231, 233), said first and second inner protrusions (31, 32) extending respectively through said first ends (211, 221) of said first and second channels (21, 22) and into said first and second channels (21, 22) toward said second ends (212, 222) of said first and second channels (21, 22), said mounting seat (3) being made from a second material that has a melting point less than that of said first material.

2. The substrate assembly of claim 1, **characterized in that** said first ends (211, 221) of said first and second channels (21, 22) are spaced apart from each other by a first distance (24), said second ends (212, 222) of said first and second channels (21, 22) being spaced apart from each other by a second distance (25) that is different from said first distance (24).

3. The substrate assembly of claim 2, **characterized in that** said first distance (24) is greater than said second distance (25).

4. The substrate assembly of any one of claims 1 to 3, **characterized in that** said first and second channels (21, 22) intersect each other.

5. The substrate assembly of any one of claims 1 to 4, **characterized in that** said substrate (2) is further formed with a third channel (26) that extends inwardly and obliquely from said first region (231) toward said second region (232) in the first direction (213) and that is spaced apart from said first channel (21), said mountingseat (3) further having a third inner protrusion (34) that protrudes from said outer layer (33) and into said third channel (26).

6. The substrate assembly of any one of claims 1 to 5, **characterized in that** said first and third regions (231, 233) are coplanar, said second channel (22) extending inwardly and obliquely relative to said third region (233) from said third region (233) toward said second region (232) in said second direction (223).

7. The substrate assembly of any one of claims 1 to 5, **characterized in that** said first and third regions (231, 233) are non-coplanar, and said third region (233) extends between said first and second regions (231, 232), said second channel (22) extending inwardly and obliquely relative to said third region (233) from said third region (233) toward said first channel (21) in the second direction (223).

8. The substrate assembly of any one of claims 1 to 7, **characterized in that** said second material is molded over said outer surface (23) of said substrate (2) to form said mounting seat (3).

9. The substrate assembly of any one of claims 1 to 8, **characterized in that** said first material is metal, and said second material is selected from the group consisting of a plastic material, glass, and a ceramic material.

10. The substrate assembly of claim 9, **characterized in that** said second material is a plastic material.

11. A method of manufacturing a substrate assembly of heterogeneous materials, the method being **characterized by**:
providing a substrate (2) having an outer surface (23) that has first, second and third regions (231, 232, 233), the first and second regions (231, 232) being non-coplanar, the second and third regions (232, 233) being non-coplanar;
forming at least first and second channels (21, 22) in the substrate (2), the first channel (21) extending inwardly from the first region (231) toward the second region (232) in a first direction (213), and having a first end (211) that terminates at the first region (231) and a second end (212) that is distal from the first end (211), the second channel (22) extending inwardly from the third region (233) in a second direction (223) that crosses the first direction (213), and having a first end (221) that terminates at the third region (231), and a second end (222) that is distal from the first end (221) of the second channel (22); and
forming a mounting seat (3) having an outer layer (33) and at least first and second inner protrusions (31, 32) that protrude outwardly from the outer layer (33), the outer layer (33) being formed on the first and third regions (231, 233), the first and second inner protrusions (31, 32) extending respectively through the first ends (211, 221) of the first and second channels (21, 22) and into the first and second channels (21, 22) toward the second ends (212, 222) of the first and second channels (21, 22), the mounting seat (3) being made from a second material that has a melting point less than that of the first material.

12. The method of claim 11, **characterized in that** the first ends (211, 221) of the first and second channels (21, 22) are spaced apart from each other by a first distance (24), the second ends (212, 222) of the first and second channels (21, 22) being spaced apart from each other by a second distance (25) that is different from the first distance (24).

13. The method of claim 12, **characterized in that** the first distance (24) is greater than the second distance (25).

14. The method of any one of claims 11 to 13, **characterized in that** formation of the mounting seat (3) is conducted by melting and molding the second material over the outer surface (23) of the substrate (2).

15. The method of any one of claims 11 to 14, **characterized in that** the substrate (2) is made from metal, and the second material is selected from the group consisting of a plastic material, glass, and a ceramic material.
